# NEUE EUROPÄISCHE PATENTSCHRIFT

(11) **EP 1 397 201 B2**
(45) Veröffentlichungstag und Bekanntmachung des Hinweises auf die Entscheidung über den Einspruch: **11.08.2010**
(45) Hinweis auf die Patenterteilung: 11.01.2006
(21) Anmeldenummer: 02743187.3
(22) Anmeldetag: 13.06.2002
(51) Int. Cl.: B01J 19/00, C30B 7/00, C30B 29/58

(54) **REAKTIONSGEFÄSS ZUR HERSTELLUNG VON PROBEN**
REACTION VESSEL FOR PRODUCING SAMPLES
RECIPIENT DE REACTION SERVANT A PRODUIRE DES ECHANTILLONS

(30) Priorität: 18.06.2001 US 883435; 18.06.2001 AT 9412001
(43) Veröffentlichungstag der Anmeldung: 17.03.2004
(73) Patentinhaber: Greiner Bio-One GmbH, 72636 Frickenhausen (DE)
(72) Erfinder: KNEBEL, Günther, 72622 Nürtingen (DE); NYARSIK, Lajos, 10369 Berlin (DE); EICKHOFF, Holger, Friedrich, Heinrich, 27211 Bassum (DE); LEHRACH, Hans, 14129 Berlin (DE)
(74) Vertreter: Secklehner, Günter
(86) Internationale Anmeldenummer: PCT/EP2002/006492
(87) Internationale Veröffentlichungsnummer: WO 2002/102503

(56) Entgegenhaltungen:
- EP-A1- 0 553 539
- WO-A-00/78445
- US-A- 5 096 676
- US-A- 5 130 105
- US-A- 5 419 278
- US-A- 5 641 681
- US-A- 6 039 804
- US-B2- 6 913 732
- ' Crystallization, Research Tools', Bd. 6, teil 1 1996, HAMTON RESEARCH
- Purchase order of the university of New South Wales dated July 26, 1996
- Invoice from Douglas Instruments dated August 9, 1996
- CHAYEN N. E. ACTA CRYST. D50 1994, Seiten 456 - 458
- Screenshot from the internet web site of Douglas Instruments
- Hampton Research-Plates-Crystal Clear, (http:www-hampton research.com/catalog/3128, download Jan. 18, 2001)
- 'Flyer of Douglas Instruments concerning Protein Crystallization according to the IMPAX 1-5 system',
- Screenshot of the Hampton Research website
- A letter dated March 3, 1994 concerning a "mail shot campaign"
- Invoice dated 11/11/94
- "Declaration in lieu of oath"
- Affidavit vom Dr. Ma Sha
- KATALOG WEBSEITE: '"CrystalQuick Standard Profile - Round Bottom Plate"',
- '"Advanced high-Throughput Platforms for Protein Crystallisation"', Juni 2007, FORUM, TECHNICAL NOTES AND APPLICATIONS FOR LABORATORY WORK

## Beschreibung

Die Erfindung betrifft ein Reaktionsgefäß bestehend aus einem Gehäuseunterteil und einer zumindest annähernd deckelartigen Gefäßabdeckung zur Herstellung einer Probe, insbesondere eines Kristalls, von einer in Lösung befindlichen oder flüssigen Substanz mit mehreren, jeweils einen eigenen Gasraum bildenden Reaktionskammern, die durch den Gehäuseunterteil gebildet sind und jede Reaktionskammer ein Reservoir und mehrere diesem zugeordnete, zum Gasaustausch miteinander und mit dem Reservoir verbundene Reaktionsbereiche aufweist, und die Reservoirs und die diesen zugeordneten Reaktionsbereiche jeweils in zueinander parallel verlaufenden Reihen mit einer vorbestimmbaren gleichen Teilung angeordnet sind und jeweils aufeinander folgende Reihen von Reservoirs in einem gleichen Abstand zueinander angeordnet sind.

Die Erfindung betrifft außerdem auch eine Gefäßabdeckung zur Herstellung einer Probe, insbesondere eines Kristalls, von einer in Lösung befindlichen oder flüssigen Substanz mit mehreren Reaktionsbereichen an einer Unterseite, entsprechend dem Oberbegriff des Anspruches 34.

Eines der wichtigsten Werkzeuge zur Untersuchung der Strukturen von chemischen Substanzen stellt die Röntgendiffraktion dar. Insbesondere in der modernen Molekularbiologie können durch kristallographische Untersuchungen an Makromolekülen, wie Protein- und Nukleinsäuren und deren zahlreichen Komplexen wertvolle Aufschlüsse über deren Eigenschaften und Wirkungsweisen erzielt werden.

Um Strukturanalysen durch Röntgendiffraktionsmessungen durchführen zu können, ist die wichtigste Voraussetzung die Herstellung von ausreichend großen und möglichst fehlerfreien Kristallen, insbesondere Einkristallen, der zu untersuchenden Substanz. Da das Kristallwachstum im Falle von biologischen Makromolekülen sehr empfindlich von verschiedensten physikalischen und chemischen Parametern abhängig ist, stellt die Kristallzucht einen limitierenden Faktor bei der Strukturuntersuchung in der modernen Biologie dar.

Eine der wichtigsten Methoden zur Herstellung von Kristallen von Makromolekülen basiert auf dem Prinzip der Dampfdiffusion. Dabei wird eine kleine Menge der Makromolekülprobe mit einem Kristallisationslösungsmittel vermischt und diese Lösung in Form eines Tropfens gemeinsam mit einer davon separat gehaltenen, wesentlich größeren Menge des Kristallisationslösungsmittels in einem Behälter eingeschlossen. Durch den zwischen den Kristallisationstropfen und dem Reservoir möglichen Dampfaustausch kommt es zu einer Konzentrationsverschiebung im Kristallisationstropfen, die zu einer Übersättigung der gelösten Makromoleküle führt, wodurch allmählich in dem Tropfen ein Kristall gebildet wird.

Nachdem das Kristallwachstum von Makromolekülen sehr empfindlich von verschiedensten Parametern abhängig ist, ist es erforderlich, viele verschiedene Versuche durchzuführen, um jene Parameter zu finden, unter denen für Strukturanalysen geeignete Kristalle gezüchtet werden können.

Um viele Versuche mit verschiedensten Kombinationen der die Kristallisation beeinflussenden Variablen gleichzeitig durchführen zu können, wurden verschiedene Systeme vorgeschlagen. So ist z.B. aus der US 6,039,804 A eine Vorrichtung bekannt, die 24 Reservoirs für die Kristallisationslösungsmittel und je vier um jedes Reservoir angeordnete Tropfenkammern aufweist. Bei dieser Anordnung der Tropfenkammern als auch bei Anordnungen in anderen vorgeschlagenen Lösungen wird jedoch die auf der Vorrichtung zur Verfügung stehende Fläche zur Aufnahme von Tropfenkammern nur zu einem sehr geringen Prozentsatz genutzt. Die Erfahrung zeigt aber auch, daß bei den vorgeschlagenen Lösungen insbesondere die Präparation von Tropfenkammern in der Form von sogenannten hängenden Tropfen, die an der Unterseite einer Kammerabdeckung positioniert werden, sehr schwierig und fehleranfällig ist. Als Kammerabdeckung wird üblicherweise eine Glasplatte verwendet. Die Positionierung von Tropfen auf einer Glasplatte ist jedoch oft nicht ausreichend exakt möglich, wodurch die optische Kontrolle des Kristallwachstums erschwert wird. Da die Glasplatte üblicherweise unter Zwischenordnung einer Dichtschicht aus Silikonfett auf den Tropfenkammern aufliegt und das Silikonfett die Reibung vermindert, kann es außerdem auch häufig zu einem unbeabsichtigten Verschieben der Glasplatte kommen. Kristallisationsgefäße sind aus dem, den Stand der Technik beschreibenden Teil der US 6,913,732 B2, aus dem Katalog "Crystallization, Research Tools; Vol. 6, 1996" von Hampton Research Corp. sowie aus der EP 0 553 539 A1 bekannt.

Der Bedarf insbesondere der modernen Biologie macht es erforderlich, außerordentlich viele Kristallisationsversuche mit unterschiedlichsten Parametern gleichzeitig durchführen zu können. Diese Versuche sollten insbesondere aber auch automatisiert durchgeführt werden können, und zwar sowohl die Präparation als auch die während des relativ lang dauernden Kristallisationsprozesses erforderlichen, durch mikroskopische Beobachtung durchgeführten Kontrollen des Kristallwachstums betreffend.

Die Aufgabe der Erfindung liegt daher darin, ein Reaktionsgefäß zur Herstellung einer Probe, insbesondere eines Kristalls, zu schaffen, mit der es möglich ist, eine Vielzahl von Herstellungsprozessen bei unterschiedlichen Prozeßparametern mit sehr hoher Effizienz durchzuführen.

Die Aufgabe der Erfindung wird durch die Merkmale des Kennzeichenteils des Anspruches 1.

Der Vorteil dieses Reaktionsgefäßes liegt darin, daß durch die Anordnung der Behälter bzw. der Reaktionsbereiche in parallel zueinander verlaufenden Reihen eine sehr hohe Dichte der Behälter bzw. der Reaktionsbereiche erreicht werden kann. Diese Anordnung bietet auch bei der Befüllung der Behälter mit dem Kristallisationslösungsmittel bzw. der Befüllung der Reaktionsbereiche mit den in Kristallisationslösung gelösten Proben den Vorteil, daß dazu Befüllungsvorrichtungen verwendet werden können, die zum gleichzeitigen Befüllen mehrerer Behälter bzw. Reaktionsbereiche geeignet sind. Es wird damit auch erreicht, dass durch das Zusammenfügen des Gehäuseunterteils mit der Gefäßabdeckung alle Reaktionskammern auf einmal verschlossen werden.

Vorteilhaft sind weiters die Ausbildungen des Reaktionsgefäßes, wobei die Reaktionskammern gleichartig gestaltet sind und die Unterseiten der Gefäßböden der Reaktionskammern von einer zur Aufstandsebene parallelen Ebene berührt werden, da durch die gleichartigen Reaktionskammern und deren ebener Anordnung insbesondere bei automatisiert durchgeführten Manipulationen wie dem Befüllen oder dem optischen Detektieren relativ zu gleichartigen Bezugspunkten von Reaktionskammern auch für verschiedene Reaktionskammern stets die gleichen parallel zur Aufstandsebene auszuführenden Verschiebungen erforderlich sind.

Durch die Ausbildungen, wonach jeweils aufeinanderfolgende Reihen von Reservoirs in einem vorbestimmbaren Abstand zueinander angeordnet sind, jeweils aufeinanderfolgende Reihen von Reservoirs in einem gleichen Abstand zueinander angeordnet und jeweils zueinander nächstgelegene Reservoirs zweier aufeinanderfolgender Reihen mit einem vorbestimmbaren, gleichen Abstand und in gleicher Richtung relativ zur Richtung der Reihen gegeneinander versetzt sind, ist es möglich, Befüllvorrichtungen mit besonders einfachen und regelmäßigen Anordnungen der Befüllöffnungen zu verwenden.

Nach einer anderen Ausführungsvariante, wonach die Reservoirs in einem rechtwinkeligen Raster angeordnet sind, wird die automatisierte Manipulation der Reaktionsgefäße besonders erleichtert.

Vorteilhaft ist auch eine Weiterbildung, wobei als ein Gehäuseteil ein zumindest annähernd plattenförmiger Gehäuseunterteil, der aus den Reaktionskammern zugeordneten Gefäßunterteilen und einem sich seitlich von einem Rand einer Oberseite des Gehäuseunterteils in Richtung auf die Unterseiten der Gefäßböden erstreckenden Rahmen besteht, ausgebildet ist, da durch die plattenförmige Gestaltung des Gehäuseunterteiles Reaktionsgefäße, die aus sehr wenigen, im günstigsten Fall nur zwei Gehäuseteilen bestehen, aufgebaut werden können.

Durch die Weiterbildung, bei der die Gefäßunterteile zumindest aus einem Reservoir und mehreren Reaktionsbereichen gebildet sind, in den Gefäßunterteilen drei Reaktionsbereiche ausgebildet sind und die Reservoirs und die Reaktionsbereiche zur Aufnahme von Flüssigkeiten ausgebildet sind, wird der Vorteil erreicht, daß für den Fall, daß nur die Reaktionsbereiche der Gefäßunterteile zur Durchführung von Reaktionen bzw. der Herstellung einer Probe verwendet werden sollen, zur Befüllung der Behälter und der Reaktionsbereiche nur der Gehäuseunterteil in eine für die Befüllung vorgesehene Vorrichtung eingebracht werden muß.

Durch die Ausbildung, wobei die Reaktionsbereiche der Gefäßunterteile in einer Höhe im Bereich von 5 mm bis 10 mm über dem Gefäßboden des Reservoirs angeordnet sind, wird der Vorteil erzielt, daß die Reaktionsbereiche der von oben zu erfolgenden optischen Kontrolle des Kristallisationswachstums besser zugänglich sind.

Vorteilhaft ist auch eine Ausbildung des Reaktionsgefäßes, wonach die Reaktionsbereiche der Gefäßunterteile durch Ausnehmungen mit einem Volumen im Bereich kleiner als 5 µl ausgebildet sind und die Ausnehmungen in Form eines plattenförmigen, quadratischen Quaders ausgebildet sind, da einerseits Tropfen von in Kristallisationslösung gelösten Proben in derart kleinen Volumina ausreichend gut festgehalten werden und andererseits ein Reaktionsbereich dieser Größe einer optischen Kontrolle durch ein Mikroskop gut zugänglich ist.

Durch die Weiterbildung des Reaktionsgefäßes, wobei die Böden der Ausnehmungen zumindest annähernd konvex gekrümmt sind, wird der Vorteil erzielt, daß Flüssigkeitstropfen in derart geformten Ausnehmungen leichter aufgenommen werden. Beim Einsetzen eines Flüssigkeitstropfens wirkt nämlich die Oberflächenspannung der Adhäsion zwischen den Wänden einer Ausnehmung und der Grenzfläche des Flüssigkeitstropfens um so weniger entgegen, je mehr die Form der Ausnehmung der annähernd kugelförmigen Krümmung eines Flüssigkeitstropfens entspricht.

Gemäß den Ausbildungen des Reaktionsgefäßes, wonach in Draufsicht auf die Aufstandsebene die Reihen der Reaktionsbereiche des Gehäuseunterteils jeweils neben den Reihen der Reservoirs liegen und der auf eine zur Aufstandsebene parallele Ebene bezogene Querschnitt der Reservoirs rechteckig ist, wird der zur Verfügung stehende Platz von den Reaktionsbereichen und den Behältern besonders gut ausgenützt.

Durch die vorteilhafte Weiterbildung eines Reaktionsgefäßes, wobei der Rahmen des Gehäuseunterteils und die Anordnung der Reaktionskammern gemäß einer Standardgröße einer Mikrotiterplatte ausgebildet sind und im Gehäuseunterteil eine vorbestimmbare Anzahl an Reaktionskammern ausgebildet ist, wobei die Anzahl aus einer Gruppe ausgewählt ist, die die Zahlen gebildet durch die mathematische Formel 3 x 2^{N}, wobei N eine natürliche Zahl ist, umfaßt, können standardisierte Befüllungs- und Untersuchungseinrichtungen, wie sie für Mikrotiterplatten verfügbar sind, auch für erfindungsgemäße Reaktionskammern verwendet werden.

Die Ausgestaltung des Reaktionsgefäßes, wonach der Gehäuseunterteil aus einem lichtdurchlässigen Kunststoff ausgebildet ist, bietet den Vorteil, daß für die optische Kontrolle der Kristallisation die Reaktionsbereiche von unten beleuchtet werden können.

Von Vorteil ist aber auch eine Weiterbildung des Reaktionsgefäßes, wonach die Gefäßoberteile mit mehreren Reaktionsbereichen ausgebildet sind, die Gefäßoberteile mit zwei Reaktionsbereichen ausgebildet und die Reaktionsbereiche der Gefäßoberteile zur Aufnahme von Flüssigkeiten ausgebildet sind, da dadurch eine noch effizientere Raumnutzung erreicht werden kann.

Vorteilhaft sind auch die Weiterbildungen des Reaktionsgefäßes, wobei die Reaktionsbereiche der Gefäßoberteile durch Ausnehmungen ausgebildet sind, die Ausnehmungen der Gefäßoberteile zylinderscheibenförmig ausgebildet sind und die Ausnehmungen der Gefäßoberteile mit einem Volumen im Bereich kleiner als 5 µl ausgebildet sind, da dadurch die Reaktionsbereiche wesentlich dichter angeordnet werden können und die Positionierung der hängenden Tropfen wesentlich sicherer vorgenommen werden kann. Die Gefahr des Überfließens zweier hängender Tropfen beim Präparieren und beim Aufsetzen der Gefäßabdeckung auf den Gehäuseunterteil kann damit sehr stark reduziert werden.

Durch die Ausbildung des Reaktionsgefäßes, wonach die Böden der die Reaktionsbereiche bildenden Ausnehmungen der Gefäßoberteile zumindest annähernd konvex gekrümmt sind, wird erreicht, daß Flüssigkeitstropfen in derart geformten Ausnehmungen leichter aufgenommen werden. Wegen der der kugelförmigen Krümmung eines Flüssigkeitstropfens eher entsprechenden Form solcher Ausnehmungen wird die der Adhäsion entgegengesetzte Wirkung der Oberflächenspannung beim Einfügen eines Flüssigkeitstropfens in eine Ausnehmung leichter überwunden.

Durch die Ausbildung des Reaktionsgefäßes, wonach in Draufsicht auf die Aufstandsebene die Reihen der Reaktionsbereiche der Gefäßabdeckung jeweils neben den gegebenenfalls vorhandenen Reihen der Reaktionsbereiche des Gehäuseunterteils liegen, wird der Vorteil erzielt, daß die Reaktionsbereiche des Gehäuseunterteils als auch der Gefäßabdeckung von oben beobachtet werden können, ohne daß die Gefäßabdeckung vom Gehäuseunterteil getrennt werden müßte.

Durch die Weiterbildung, wonach der Rahmen der Gefäßabdeckung und die Anordnung der Gefäßoberteile gemäß einer Standardgröße einer Mikrotiterplatte ausgebildet sind und in der Gefäßabdeckung eine vorbestimmbare Anzahl an Gefäßoberteilen ausgebildet ist, wobei die Anzahl aus einer Gruppe ausgewählt ist, die die Zahlen, gebildet durch die mathematische Formel 3 x 2^{N}, wobei N eine natürliche Zahl ist, umfaßt, wird der Vorteil erzielt, daß übliche standardisierte Befüll- und Analyseeinrichtungen für Mikrotiterplatten verwendet werden können.

Vorteilhaft ist auch die Weiterbildung, wonach die Gefäßabdeckung aus einem lichtdurchlässigen Kunststoff ausgebildet ist, da dadurch die Reaktionen in den Reaktionskammern mit licht-optischen Geräten, wie z.B. Mikroskopen, beobachtet werden können.

Durch die vorteilhafte Weiterbildung, wonach an der Gefäßabdeckung an einer den Reaktionsbereichen abgewandten Oberfläche eine Maske aufgebracht ist und diese Maske bei Draufsicht auf die Aufstandsebene die Reaktionsbereiche mit einer lichtabschirmenden Fläche umgibt, wird der Vorteil erzielt, daß die Bildqualität beeinträchtigendes Streulicht bei fotografischen Aufnahmen der Reaktionsbereiche vermieden werden kann. Bei automatisiert durchgeführten Untersuchungen der Reaktionen in den Reaktionsbereichen können die Masken auch dazu herangezogen werden, mit Hilfe optischer Sensoren die Position des Analysegerätes über dem Reaktionsbereich genau festzulegen.

Eine weitere eigenständige Lösung der Aufgabe der Erfindung wird auch durch eine Gefäßabdeckung entsprechend dem Kennzeichenteil des Anspruches 34, geschaffen.

Der Vorteil dieser Gefäßabdeckung liegt darin, daß durch die Anordnung der Reaktionsbereiche in zueinander parallelen Reihen eine rationelle Befüllung der Reaktionsbereiche möglich ist und dazu Befüllungsvorrichtungen verwendet werden können, die zum gleichzeitigen Befüllen mehrerer Reaktionsbereiche geeignet sind. Mit derartigen Gefäßabdeckungen ist es aber auch möglich, Reaktionskammern zu bilden, indem eine Gefäßabdeckung mit einem Gehäuseunterteil kombiniert wird, der an sich nur aus Reservoiren mit einer der Anordnung der Reaktionsbereiche entsprechenden Teilung ausgebildet ist.

Durch die Weiterbildung der Gefäßabdeckung, wobei die Reaktionsbereiche in Reihen mit einer gleichen Teilung und unmittelbar nebeneinander angeordnet sind, wird der Vorteil erzielt, daß Anordnungen von Reaktionsbereichen mit einer besonders hohen Dichte erreicht werden können.

Mit der Ausbildung der Gefäßabdeckung, wonach an einem Rand der Unterseite ein über die Unterseite vorstehender Rahmen ausgebildet ist, wird das Aufsetzen der Gefäßabdeckung nach Befüllung der Reaktionsbereiche auf einen mit der Gefäßabdeckung korrespondierenden Gehäuseunterteil erleichtert.

Die Weiterbildung der Gefäßabdeckung, wonach an der Unterseite Nuten ausgebildet sind, durch die Gefäßoberteile, denen zumindest ein Reaktionsbereich zugeordnet ist, begrenzt sind, wird der Vorteil erzielt, daß die Ränder der Gefäßunterteile eines der Gefäßabdeckung entsprechenden Gehäuseunterteils in die Nuten eingefügt werden können und so eine gute Abdichtung der Reaktionskammern erreicht werden kann.

Durch die Weiterbildungen der Gefäßabdeckung, wobei die Reaktionsbereiche zur Aufnahme von Flüssigkeiten ausgebildet sind, die Reaktionsbereiche durch Ausnehmungen ausgebildet sind und die Ausnehmungen zylinderscheibenförmig sind, wird der Vorteil erzielt, daß die Reaktionsbereiche dichter angeordnet werden können und die Gefahr des Überfließens zweier hängender Tropfen bei der Präparation und beim Aufsetzen der Gefäßabdeckung auf einem entsprechenden Gehäuseunterteil wesentlich weniger fehleranfällig wird.

Vorteilhaft ist auch die Weiterbildung der Gefäßabdeckung, wobei die Böden der Ausnehmungen zumindest annähernd konvex gekrümmt sind, da Flüssigkeitstropfen in derart geformten Ausnehmungen leichter aufgenommen werden. Durch die der annähernd kugelförmigen Krümmung eines Flüssigkeitstropfens eher entsprechende Form solcher Ausnehmungen wird die der Adhäsion entgegengesetzte Wirkung der Oberflächenspannung beim Einfügen eines Flüssigkeitstropfens in eine Ausnehmung reduziert.

Mit den Weiterbildungen der Gefäßabdeckung, wonach der Rahmen und die Anordnung der Gefäßoberteile gemäß einer Standardgröße einer Mikrotiterplatte ausgebildet sind und eine vorbestimmbare Anzahl an Gefäßoberteilen ausgebildet ist, wobei die Anzahl aus einer Gruppe ausgewählt ist, die die Zahlen, gebildet durch die mathematische Formel 3 x 2^{N}, wobei N eine natürliche Zahl ist, umfaßt, können übliche standardisierte Befüll- und Analyseeinrichtungen für Mikrotiterplatten vorteilhaft verwendet werden.

Durch die Weiterbildung der Gefäßabdeckung, wobei das Material ein lichtdurchlässiger Kunststoff ist, wird der Vorteil erreicht, daß die Reaktionen in den Reaktionsbereichen mit lichtoptischen Instrumenten, wie z.B. Mikroskopen, beobachtet werden können.

Vorteilhaft ist auch die Weiterbildung der Gefäßabdeckung, wobei an der den Reaktionsbereichen abgewandten Oberfläche eine Maske aufgebracht ist und diese Maske bei Draufsicht auf die Aufstandsebene die Reaktionsbereiche mit einer lichtabschirmenden Fläche umgibt, kann das die Bildqualität beeinträchtigende Streulicht bei fotografischen Aufnahmen vorteilhaft vermieden werden. Bei automatisierten Analysegeräten, die mit Hilfe optischer Sensoren die Position der Reaktionsbereiche auffinden, können diese Masken auch zur Positionsbestimmung herangezogen werden.

Die Erfindung wird im nachfolgenden anhand der in den Zeichnungen dargestellten Ausführungsbeispiele näher erläutert.

Es zeigen:
- Fig. 1: ein Reaktionsgefäß bestehend aus einem Gefäßunterteil und einem Gefäßoberteil;
- Fig. 2: einen Schnitt eines Reaktionsgefäßes gemäß Fig. 1;
- Fig. 3: eine Draufsicht eines Reaktionsgefäßes gemäß Fig. 1;
- Fig. 4: einen Gehäuseunterteil eines Reaktionsgefäßes;
- Fig. 5: einen Schnitt eines Gehäuseunterteils gemäß Fig. 4;
- Fig. 6: eine Gefäßabdeckung eines Reaktionsgefäßes;
- Fig. 7: einen Schnitt einer Gefäßabdeckung gemäß Fig. 6;
- Fig. 8: einen Schnitt eines Reaktionsgefäßes bestehend aus einem Gehäuseunterteil und einer Gefäßabdeckung in zusammengebautem Zustand;
- Fig. 9: eine Prinzipdarstellung eines Verwendungsbeispiels eines Reaktionsgefäßes.

Einführend sei festgehalten, daß in den unterschiedlich beschriebenen Ausführungsformen gleiche Teile mit gleichen Bezugszeichen bzw. gleichen Bauteilbezeichnungen versehen werden, wobei die in der gesamten Beschreibung enthaltenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind bei einer Lageänderung sinngemäß auf die neue Lage zu übertragen. Weiters können auch Einzelmerkmale oder Merkmalskombinationen aus den gezeigten und beschriebenen unterschiedlichen Ausführungsbeispielen für sich eigenständige, erfinderische oder erfindungsgemäße Lösungen darstellen.

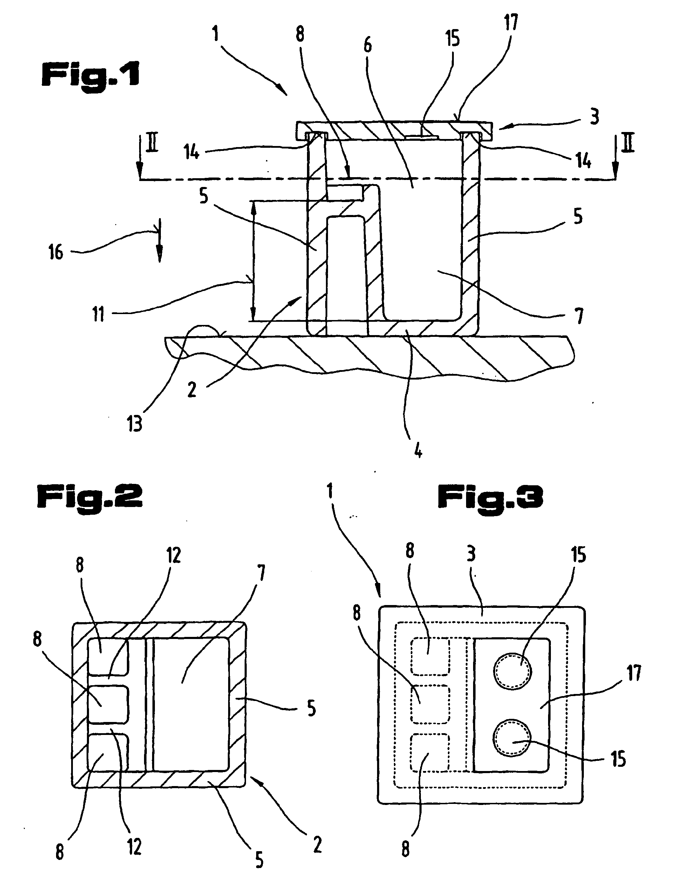

Die Fig. 1 bis 3 zeigen ein Reaktionsgefäß 1 bestehend aus einem Gefäßunterteil 2 und einem Gefäßoberteil 3. Der Gefäßunterteil 2 besteht aus einem Gefäßboden 4 und Gefäßwänden 5, die eine Reaktionskammer 6 bilden. In der Reaktionskammer 6 befinden sich ein Reservoir 7 und drei über den Gefäßboden 4 erhöht positionierte Reaktionsbereiche 8.

Das Reaktionsgefäß 1 hat eine quadratische Grundfläche mit einer Seitenlänge von ca. 10 mm. Die Reaktionsbereiche 8 sind um eine Höhe 11 von ca. 7,5 mm über dem Gefäßboden 4 angeordnet, wobei sie in einer Reihe unmittelbar hintereinander liegen und von einer der Gefäßwände 5 seitlich begrenzt werden. Der Begriff Reihe ist dabei stets im geometrischen Sinn zu verstehen, als eine lineare Anordnung von zueinander gleichen Objekten, so daß jeweils gleichartige Punkte der Objekte auf einer gemeinsamen Geraden liegen.

Die Reaktionsbereiche 8 sind durch eine Ausnehmung gebildet, wobei zwei unmittelbar benachbarte Reaktionsbereiche 8 durch eine gemeinsame Wand 12 voneinander getrennt sind. Das Volumen eines Reaktionsbereichs 8 beträgt ungefähr 4 µl, wobei die Form zumindest annähernd der Form eines Quaders mit den Seitenlängen von 2 mm x 2 mm x 1 mm entspricht.

Der auf eine zu einer Aufstandsebene 13 parallele Ebene bezogene Querschnitt des Reservoirs 7 ist viereckig, insbesondere rechteckig ausgebildet.

Das Reservoir 7 ist zur Aufnahme von flüssigen Agenzien und der Reaktionsbereich 8 für die Aufnahme einer Probe bestimmt. Das Reservoir 7 ist mit dem Agens so zu befüllen, daß sich der Reaktionsbereich 8 stets über dem Niveau des Flüssigkeitsspiegels im Reservoir 7 befindet. Bei Verwendung des Reaktionsgefäßes 1 in seiner Gebrauchslage kann somit zwischen dem Reservoir 7 und dem Reaktionsbereich 8 kein Flüssigkeitsaustausch stattfinden, d.h. daß ein Austausch von Substanzen des Agens bzw. der Probe nur in der Form eines Gases bzw. Dampfes erfolgen kann.

Der Gefäßoberteil 3 ist in plattenförmiger Gestalt ausgebildet und liegt unter Zwischenschaltung einer Dichtschicht 14 an den Gefäßwänden 5 des Gefäßunterteils 2 dichtend auf. Der Gefäßoberteil 3 ist mit zwei Reaktionsbereichen 15 ausgebildet, die ebenfalls mit der Reaktionskammer 6 in Gasverbindung stehen. Die Reaktionsbereiche 15 sind durch zylinderscheibenförmige Ausnehmungen im Gefäßoberteil 3 ausgebildet.

Das Reservoir 7 und die Reaktionsbereiche 8 und 15 sind zur Aufnahme von Flüssigkeiten ausgebildet.

Das Reaktionsgefäß 1 dient der Durchführung von Reaktionen, bei denen zwischen einem im Reservoir 7 befindlichen Agens und in den Reaktionsbereichen 8 bzw. 15 befindlichen Proben ein Gasaustausch stattfinden muß. Eine solche Reaktion ist z.B. die Herstellung eines Kristalls aus einer in einer Kristallisationslösung gelösten Probe nach dem Prinzip der Dampfdiffusion. In den in die Reaktionsbereiche 8 und 15 positionierten Tropfen von in einer Kristallisationsflüssigkeit gelösten Proben kommt es durch die durch den Gasaustausch mit der sich im Reservoir 7 befindlichen Kristallisationslösung bewirkten Konzentrationsverschiebung zur Ausbildung von Kristallen.

Die Reaktionsbereiche 8 und 15 sind mit einem Volumen von ca. 4 µl ausgebildet. Ein in einem Reaktionsbereich 8 positionierter Tropfen wird als sitzender Tropfen und ein in einem Reaktionsbereich 15 positionierter Tropfen als hängender Tropfen bezeichnet. Die Böden der die Reaktionsbereiche 8 und 15 bildenden Ausnehmungen können auch zumindest annähernd konvex gekrümmt sein (nicht dargestellt). D.h. die Böden bzw. die Bodenbereiche der Ausnehmungen können durch Erweiterungen der Ausnehmungen in der Form eines Kegels, eines Kegelstumpfes oder eines Kugelabschnittes oder Kombinationen solcher Körper ausgebildet sein. Durch derart ausgebildete Reaktionsbereiche 8, 15 wird das Festhalten der Flüssigkeitstropfen unterstützt.

Der Gefäßoberteil 3 besteht aus einem durchsichtigen Werkstoff, so daß das Kristallwachstum in den Reaktionsbereichen 8 und 15 durch den Gefäßoberteil 3 hindurch beobachtet werden kann. Bei Draufsicht auf das Reaktionsgefäß 1 entsprechend der durch einen Pfeil 16 in Fig. 1 gezeigten Blickrichtung liegt die Reihe der Reaktionsbereiche 8 neben der aus den beiden Reaktionsbereichen 15 gebildeten Reihe. Demgemäß liegt die Reihe der Reaktionsbereiche 15 über dem Reservoir 7. Die Reihe der Reaktionsbereiche 8 ist somit gegenüber der Reihe der Reaktionsbereiche 15 seitlich versetzt, wodurch die Reaktionsverläufe in den Reaktionsbereichen 8 und 15 auch, ohne das Reaktionsgefäß öffnen zu müssen, ungehindert beobachtet werden können.

Fig. 3 zeigt eine Draufsicht auf das Reaktionsgefäß 1 entsprechend der durch den Pfeil 16 in Fig. 1 angegebenen Richtung. Am Gefäßoberteil 3 des Reaktionsgefäßes 1 ist eine Maske 17 angebracht. Die Maske 17 besteht aus einer lichtabschirmenden bzw. lichtundurchlässigen Schicht und umschließt die Reaktionsbereiche 15. Durch die lichtabschirmende Wirkung der Maske 17 wird störendes Streulicht bei der Beobachtung der Reaktionsverläufe in den Reaktionsbereichen 15 ausgeblendet.

Ein Reaktionsgefäß 1, wie in den Fig. 1 bis 3 beschrieben, ist für Versuchsdurchführungen, bei denen es auf besondere Miniaturisierung ankommt, geeignet. So ist es z.B. möglich, eine größere Zahl solcher Reaktionsgefäße 1 in einem dafür vorgesehenen Aufnahmebehälter anzuordnen und so eine große Zahl von Reaktionen gleichzeitig durchzuführen.

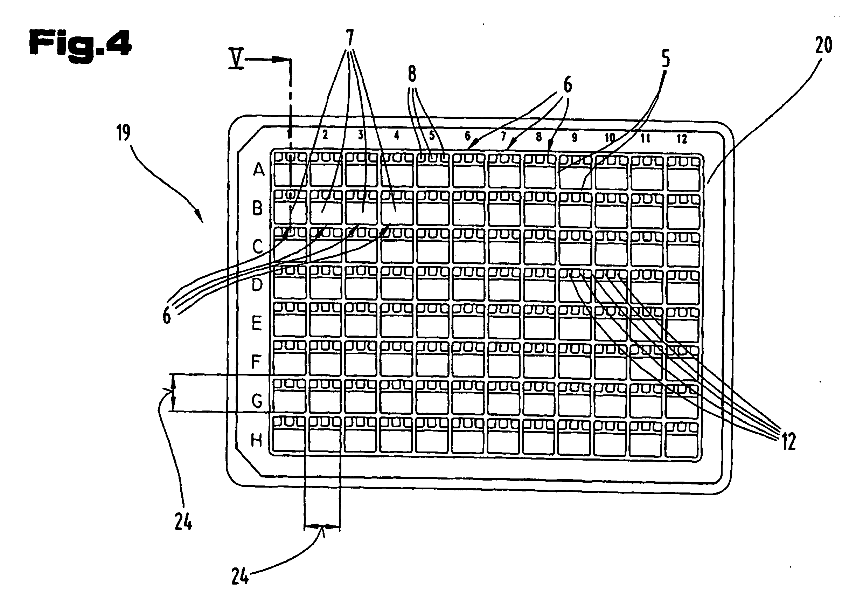

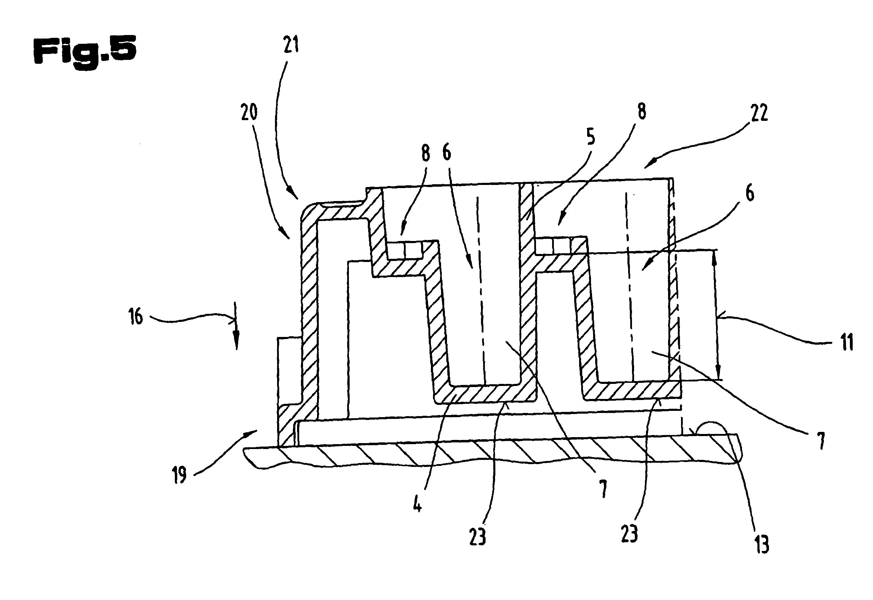

Die Fig. 4 und 5 zeigen einen Gehäuseunterteil 19 eines erfindungsgemäßen Reaktionsgefäßes. Der Gehäuseunterteil 19 besteht aus einem Rahmen 20, in dem Reaktionskammern 6 angeordnet sind. Der Gehäuseunterteil 19 ist somit annähernd plattenförmig ausgebildet. Der Rahmen 20 erstreckt sich von einem Rand 21 einer Oberseite 22 des Gehäuseunterteils 19 in Richtung auf die Unterseiten 23 der Gefäßböden 4. Der innere Aufbau einer Reaktionskammer 6 entspricht dem eines Gefäßunterteils 2, wie in den Fig. 1 bis 3 beschrieben. Das heißt, die Reaktionskammern 6 des Gehäuseunterteils 19 sind gleich aufgebaut und eben angeordnet, so daß die Unterseiten 23 der Gefäßböden 4 der Reaktionskammern 6 von einer zur Aufstandsebene 13 parallelen Ebene berührt werden. Dabei werden jeweils zueinander nächstgelegene Reaktionskammern 6 durch zumindest eine gemeinsame Gefäßwand 5 voneinander getrennt. Die Grundflächen der Reaktionskammern 6 haben eine quadratische Form.

In einem Gehäuseunterteil 19 sind in einem Rahmen 20, der gemäß einer Standardgröße einer Mikrotiterplatte ausgebildet ist, die Reaktionskammern 6 in einem rechtwinkeligen Raster mit einer Reihenweite 24 von 9 mm angeordnet. Der Gehäuseunterteil 19 verfügt somit über insgesamt 96 Reaktionskammern 6. Dabei bilden jeweils benachbarte Reservoirs 7, die nur durch eine Gefäßwand 5 voneinander getrennt sind, insgesamt 8 jeweils voneinander getrennte und zueinander parallele Reihen unmittelbar nebeneinanderliegender Reservoirs 7. Diese Reihen sind parallel zur Längserstreckung des Gehäuseunterteils 19 ausgerichtet, wobei jeweils aufeinanderfolgende Reihen von Reservoirs in einem gleichen Abstand angeordnet sind. In einer alternativen Ausführungsvariante eines Gehäuseunterteils 19 können die Reihen aber auch normal zur Längserstreckung ausgerichtet sein.

Es können selbstverständlich auch Gehäuseunterteile 19 mit einer anderen, einer Standardgröße von Mikrotiterplatten entsprechenden Anzahl an Reaktionskammern 6, wie z.B. 24, 48, 96, 192, 384, 768, 1536, 3072, 6144 usw., hergestellt werden, d.h. die Anzahl kann aus einer Gruppe ausgewählt sein, die die Zahlen, gebildet durch die mathematische Formel 3 x 2^{N}, wobei N eine natürliche Zahl ist, umfaßt.

Selbstverständlich sind auch Gehäuseunterteile 19 möglich, bei denen jeweils aufeinanderfolgende Reihen von Reaktionskammern 6 um einen vorbestimmbaren, gleichen Abstand in Richtung der Längserstreckung der Reihen gegeneinander versetzt sind.

In einer Reaktionskammer 6 sind jeweils 3 Reaktionsbereiche 8 in einer Reihe hintereinanderliegend angeordnet. Dabei sind die Reaktionsbereiche 8 parallel zur Längserstreckung des Gehäuseunterteils 19 angeordnet, so daß diese insgesamt acht voneinander getrennte Reihen jeweils unmittelbar nebeneinanderliegende Reaktionsbereiche bilden. Es sind somit die Reihen der Reservoirs 7 und der Reaktionsbereiche 8 jeweils zueinander parallel ausgerichtet und liegt stets, bezogen auf die Draufsicht entsprechend der Richtung des Pfeils 16 in Fig. 5, neben einer Reihe von Reservoirs 7 eine Reihe von Reaktionsbereichen 8. Entsprechend der regelmäßigen Anordnung der Reaktionskammern 6 im Gehäuseunterteil 19 mit der Reihenweite 24 weisen die Reihen der Reservoirs 7 und der Reaktionsbereiche 8 eine jeweils gleiche Teilung über ihre Länge auf. Diese Anordnung erweist sich insbesondere bei der automatisiert durchgeführten Befüllung der Reaktionsbereiche 8 und der Reservoirs 7 als günstig.

In der Anordnung der Reaktionskammern 6, wie in Fig. 4 dargestellt, wird das zur Verfügung stehende Volumen bzw. die zur Verfügung stehende Grundfläche des Gehäuseunterteils 19 sehr effizient ausgenutzt. Selbstverständlich ist es auch möglich, die Grundfläche der Reaktionskammern 6 rechteckig oder in der Form eines Parallelogramms auszubilden. Es ist auch möglich, die zueinander parallelen Reihen der Reaktionskammern 6 gegeneinander in Richtung der Längserstreckung des Gehäuseunterteils 19 versetzt anzuordnen. In einer anderen Ausführungsform ist es auch möglich, die Reaktionskammern 6 mit regelmäßig sechseckigem Querschnitt auszubilden und die Reaktionskammern 6 bienenwabenartig anzuordnen.

Das Material, aus dem der Gehäuseunterteil 19 gefertigt ist, ist ein lichtdurchlässiger Kunststoff, bevorzugt Polystyrol. Selbstverständlich kann der Gehäuseunterteil 19 auch aus einem anderen Werkstoff hergestellt werden, bevorzugt Kunststoffe, die sich für die Formgebung mit Spritzgußtechnik eignen.

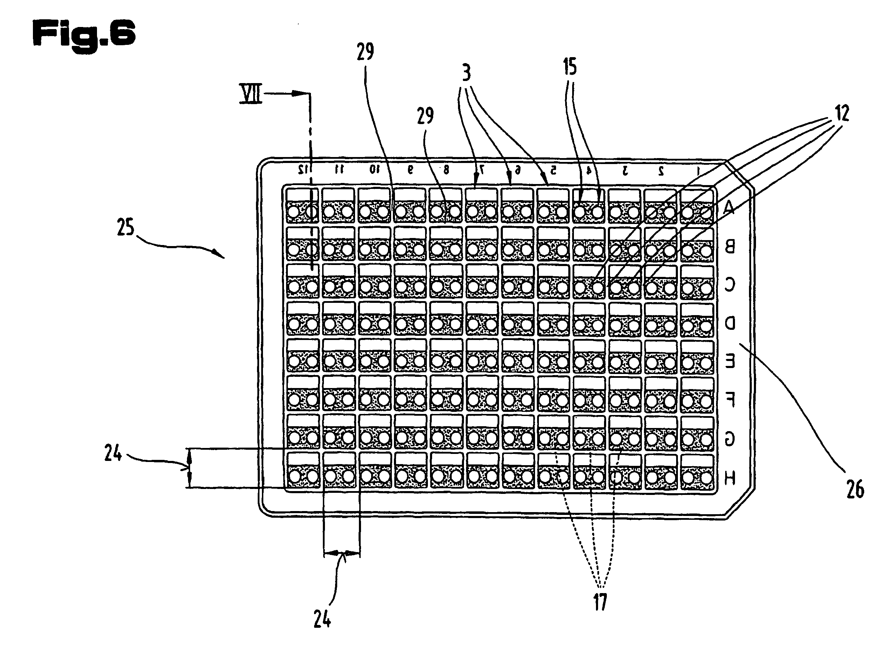

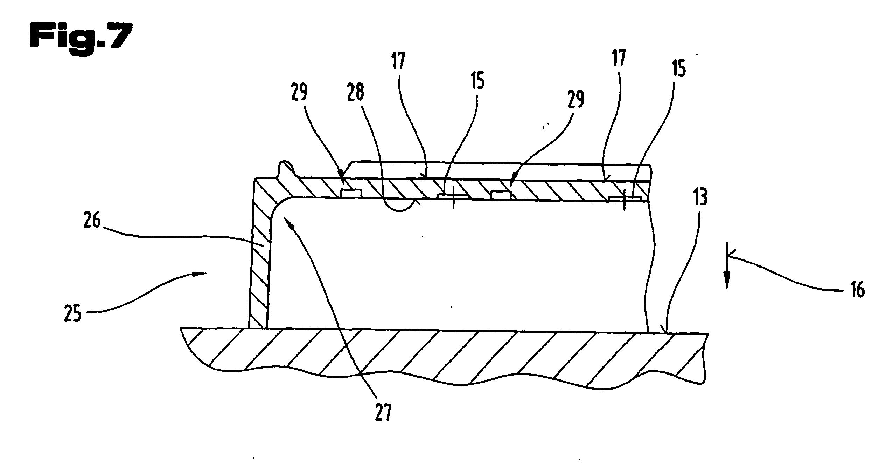

Die Fig. 6 und 7 zeigen eine Gefäßabdeckung 25 eines erfindungsgemäßen Reaktionsgefäßes. Die Gefäßabdeckung 25 umfaßt einen Rahmen 26 und eine damit einstückig verbundene Anordnung von 96 Gefäßoberteilen 3, wie in den Fig. 1 bis 3 beschrieben. Die Gefäßabdeckung 25 ist somit annähernd deckelartig ausgebildet. An einem Rand 27 einer Unterseite 28 der Gefäßabdeckung 25 steht der Rahmen 26 über die Unterseite 28 vor. Die Gefäßoberteile 3 sind dabei in einem rechtwinkeligen Raster mit einer Reihenweite 24 von 9 mm in Richtung der Längserstreckung der Gefäßabdeckung 25 als auch in einem rechten Winkel zur Längserstreckung der Gefäßabdeckung 25 angeordnet. Der Gehäuseoberteil 25 ist somit gemäß einer Standardgröße einer Mikrotiterplatte ausgebildet. Dabei verfügen jeweils unmittelbar benachbarte Gefäßoberteile 3 über eine gemeinsame Nut 29. Die Nuten 29 sind dabei so angeordnet, daß sie auf die Gefäßwände 5 des Gefäßunterteils 2 (Fig. 4 und 5) aufgesetzt werden können. Jeder Gefäßoberteil 3 umfaßt zwei zylinderscheibenförmig ausgebildete Reaktionsbereiche 15, so daß insgesamt acht Reihen nebeneinander angeordneter Reaktionsbereiche 15 ausgebildet sind. Diese Reihen sind parallel zur Längserstreckung der Gefäßabdeckung 25 ausgerichtet und weisen über ihre Länge eine gleiche Teilung auf.

Es können selbstverständlich auch Gefäßabdeckungen 25 mit einer anderen, einer Standardgröße von Mikrotiterplatten entsprechenden Anzahl an Reaktionskammern 6, wie z.B. 24,48, 96, 192, 384, 768, 1536, 3072, 6144 usw., hergestellt werden, d.h. die Anzahl kann aus einer Gruppe ausgewählt sein, die die Zahlen, gebildet durch die mathematische Formel 3 x 2^{N}, wobei N eine natürliche Zahl ist, umfaßt.

Die Gefäßabdeckung 25 besteht aus einem lichtdurchlässigen Kunststoff, vorzugsweise Polystyrol. Selbstverständlich können auch andere Werkstoffe verwendet werden, bevorzugt solche, die mit entsprechend geformten Matrizen durch Spritzgußverfahren verarbeitet werden können.

An der den Reaktionsbereichen 15 abgewandten Oberfläche der Gefäßabdeckung 25 sind Masken 17 aus einem lichtundurchlässigen Material aufgebracht, die bei Draufsicht entsprechend der Richtung des Pfeils 16 die Reaktionsbereiche 15 von außen umschließen. Die Masken 17 können auf der Gefäßabdeckung 25 aufgedruckt sein, oder durch eine die Masken 17 tragende Folie an der Gefäßabdeckung 25 befestigt sein. Eine Masken 17 tragende Folie kann auch durch "in mould labelling" angeformt sein.

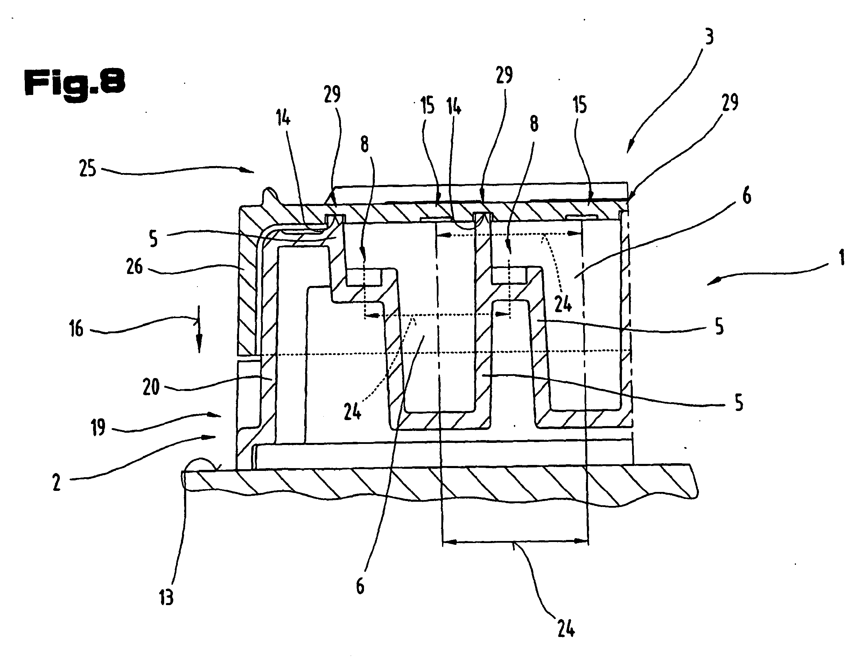

Die Fig. 8 zeigt ein Gefäßunterteil 2 und ein Gefäßoberteil 3 eines Reaktionsgefäßes 1 in zusamrnengebautem Zustand.

Der Rahmen 26 der Gefäßabdeckung 25 ist über den Rahmen 20 des Gehäuseunterteils 19 gestülpt. Ebenso sitzen die Nuten 29 der Gefäßabdeckung 25 auf den oberen Rändern der Gefäßwände 5 des Gefäßunterteils 19, wobei die Reaktionskammern 6 durch eine zusätzliche Dichtschicht 14 in den Nuten 29 nach außen hin abgedichtet sind. Jeweils unmittelbar benachbarte Reaktionskammern 6 sind um die Reihenweite 24 seitlich gegeneinander versetzt, wobei sie durch eine gemeinsame Gefäßwand 5 voneinander abgegrenzt sind. Ebenso sind die Reaktionsbereiche 8 zweier unmittelbar benachbarter Reaktionskammern 6 um die Reihenweite 24 seitlich gegeneinander versetzt, dies trifft analog auch auf die Reaktionsbereiche 15 der Gefäßabdeckung 25 zu. Demgegenüber sind aber die Reaktionsbereiche 15 der Gefäßabdekkung 25 um etwa die Hälfte des Wertes der Reihenweite 24 seitlich gegenüber den Reaktionsbereichen 8 des Gehäuseunterteils 19 versetzt.

Entsprechend den in den Beschreibungen zu den Fig. 4 und 5 und den Fig. 6 und 7 gemachten Ausführungen betreffend die Reihen unmittelbar benachbarter Reaktionsbereiche 8 bzw. von Reihen unmittelbar benachbarter Reaktionsbereiche 15 bedeutet dies nun insgesamt, daß Reihen unmittelbar benachbarter Reaktionsbereiche 8 und Reihen unmittelbar benachbarter Reaktionsbereich 15 mit einer seitlichen Versetzung entsprechend etwa der Hälfte der Reihenweite 24 aufeinander folgen. Außerdem ist jeder Reihe von Reservoirs 7 zumindest eine Reihe von Reaktionsbereichen 8 zugeordnet.

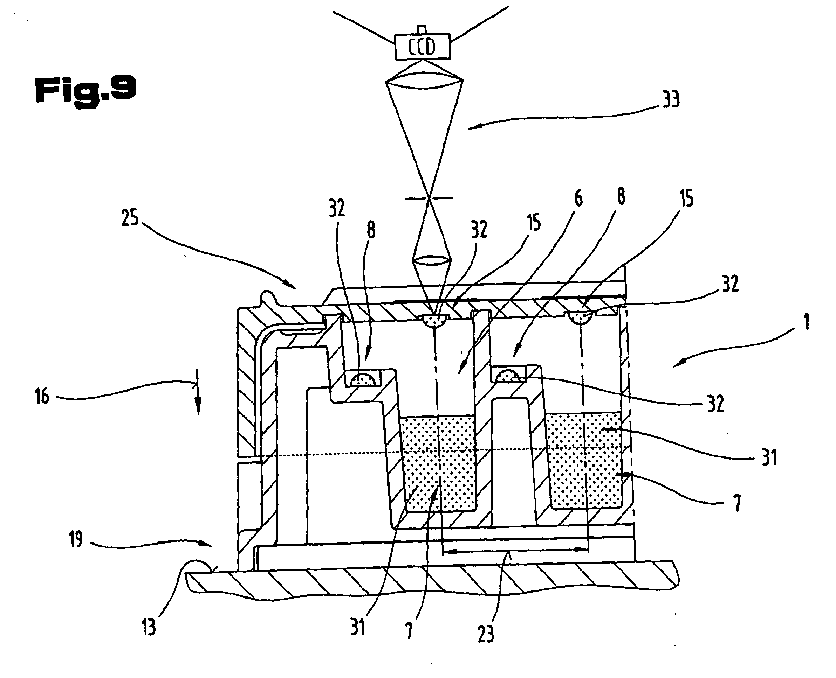

Fig. 9 zeigt eine Prinzipdarstellung der erfindungsgemäßen Verwendung eines Reaktionsgefäßes 1. Die Reservoirs 7 der Reaktionskammern 6 sind mit einem Agens 31 befüllt, während sich in den Reaktionsbereichen 8 bzw. in den Reaktionsbereichen 15 eine Reaktionslösung 32 befindet. Innerhalb einer Reaktionskammer 6 kann zwischen dem Agens 31 und den Reaktionslösungen 32 ein Austausch von Substanzen durch Dampfdiffusion erfolgen.

Da zumindest die Gefäßabdeckung 25 aus einem lichtdurchlässigen Material hergestellt ist, können die Reaktionsverläufe in den Reaktionslösungen 32 mit einem Mikroskop 33 durch die Gefäßabdeckung 25 hindurch beobachtet werden. Da außerdem die Reaktionsbereiche 8 und die Reaktionsbereiche 15 gegeneinander seitlich versetzt sind, kann eine Beobachtung der Reaktionsverläufe in den Reaktionslösungen 32 in beiden Reaktionsbereichen 8, 15 erfolgen, ohne daß die Reaktionskammern 6 geöffnet werden müßten.

Ein Beispiel für eine Reaktion, die in einem Reaktionsgefäß 1 durchgeführt werden kann, ist die Herstellung eines Kristalls aus einer in einer Kristallisationslösung gelösten Probe nach dem Prinzip der Dampfdiffusion, wie bereits in der Beschreibung der Fig. 1 bis 3 ausgeführt wurde. Durch die Dampfdiffusion kommt es zu einer Konzentrationsverschiebung in den Reaktionslösungen 32 der Reaktionsbereiche 8 und 15 und dadurch bedingt zur Ausbildung von Kristallen, insbesondere von Einkristallen. Die sich in den Reaktionslösungen 32 bildenden Kristalle können mit Hilfe des Mikroskops 33 von außen beobachtet werden.

Der Ordnung halber sei abschließend darauf hingewiesen, daß zum besseren Verständnis des Aufbaus des Reaktionsgefäßes 1 diese bzw. deren Bestandteile teilweise unmaßstäblich und/oder vergrößert und/oder verkleinert dargestellt wurden.

### Bezugszeichenaufstellung

- 1: Reaktionsgefäß
- 2: Gefäßunterteil
- 3: Gefäßoberteil
- 4: Gefäßboden
- 5: Gefäßwand

- 6: Reaktionskammer
- 7: Reservoir
- 8: Reaktionsbereich
- 9:
- 10:

- 11: Höhe
- 12: Wand
- 13: Aufstandsebene
- 14: Dichtschicht
- 15: Reaktionsbereich

- 16: Pfeil
- 17: Maske
- 18:
- 19: Gehäuseunterteil
- 20: Rahmen

- 21: Rand
- 22: Oberseite
- 23: Unterseite
- 24: Reihenweite
- 25: Gefäßabdeckung

- 26: Rahmen
- 27: Rand
- 28: Unterseite
- 29: Nut
- 30:

- 31: Agens
- 32: Reaktionslösung
- 33: Mikroskop

## Patentansprüche

1. Reakhonsgefäß bestehend aus einem Gehäuseunterteil (2) und einer zumindest annähernd deckelartigen Gefäßabdeckung (25) zur Herstellung einer Probe, insbesondere eines Kristalls, von einer sich in Lösung befindlichen oder flüssigen Substanz mit mehreren, jeweils einen eigenen Gas-, raum bildenden Reaktionskammern (6), die gleich aufgebaut und durch den Gehäuseunterteil (2) gebildet sind, wobei jede Reaktionskammer (6) ein Reservoir (7) und mehrere diesem zugeordnete, zum Gasaustausch miteinander und mit dem Reservoir (7) verbundene Reaktionsbereiche (8, 15) aufweist und die Reservoirs (7) und die diesen zugeordneten Reaktionsbereiche (8, 15) jeweils in zueinander parallel verlaufenden Reihen mit einer vorbestimmbaren, gleichen Teilung angeordnet sind und jeweils aufeinander folgende Reihen von Reservoirs (7) in einem gleichen Abstand zueinander angeordnet sind, **dadurch gekennzeichnet, dass** die Reservoirs (7) und die Reaktionsbereiche (8, 15) jeweils in den Reihen unmittelbar nebeneinander angeordnet sind und jeweils unmittelbar benachbarte Reaktionskammern (6) durch eine gemeinsame Gefäßwand (5) voneinander abgegrenzt sind, und dass die Gefäßabdeckung (25) mit Nuten (29) an einer Unterseite (28) ausgebildet ist und durch die Nuten (29) Gefäßoberteil (3), die zumindest einen Reaktionsbereich (15) enthalten, begrenzt sind, wobei die Nuten (29) dabei so angeordnet sind, dass sie auf die Gefäßwände (5) des Gehäuseunterteils (2) aufgesetzt werden können.

2. Reaktionsgefäß nach Anspruch 1, **dadurch gekennzeichnet, dass** Unterseiten (23) von Gefäßböden (4) der Reaktionskammern (6) von einer zu einer Aufstandsebene (13) parallelen Ebene berührt werden.

3. Reaktionsgefäß nach Anspruch 1 oder 2, **dadurch gekennzeichnet, dass** jeweils aufeinander folgende Reihen von Reservoirs (7) in einem vorbestimmbaren Abstand zueinander angeordnet sind.

4. Reaktionsgefäß nach einem der vorhergehenden Ansprüche, **dadurch gekennzeichnet, dass** jeweils zueinander nächstgelegene Reservoirs (7) zweier aufeinander folgender Reihen mit einem vorbestimmbaren, gleichen Abstand und in gleicher Richtung relativ zur Richtung der Reihen gegeneinander versetzt sind.

5. Reaktionsgefäß nach einem der vorhergehenden Ansprüche, **dadurch gekennzeiehnet, dass** die Reservoirs (7) in einem rechtwinkeligen Raster angeordnet sind.

6. Reaktionsgefäß nach einem der vorhergehenden Anspruche, **dadurch gekennzeichnet, dass** als ein Gehäuseteil ein zumindest annähernd plattenförmiger Gehäuseunterteil (19), der aus den Reaktionskammern (6) zugeordneten Gefäßunterteilen (2) und einem sich seitlich von einem Rand (21) einer Oberseite (22) des Gehäuseunterteils (19) in Richtung auf die Unterseiten (23) der Gefäßböden (4) erstreckenden Rahmen (20) besteht, ausgebildet ist.

7. Reaktionsgefäß nach einem der vorhergehenden Ansprüche, **dadurch gekennzeichnet, dass** die Gefäßunterteile (2) zumindest aus einem Reservoir (7) und zumindest einem Reaktionsbereich (8) gebildet sind.

8. Reaktionsgefäß nach einem der vorhergehenden Ansprüche, **dadurch gekennzeichnet, dass** in den Gefäßunterteilen (2) drei oder mehrere Reaktionsbereiche (8) ausgebildet sind.

9. Reaktionsgefäß nach einem der vorhergehenden Ansprüche, **dadurch gekennzeichnet, dass** die Reservoirs (7) und die Reaktionsbereiche (8, 15) zur Aufnahme von Flüssigkeiten ausgebildet sind.

10. Reaktionsgefäß nach einem der vorhergehenden Ansprüche, **dadurch gekennzeichnet, dass** die Reaktionsbereiche (8) der Gefäßunterteile (2) in einer Höhe (11) im Bereich von 5 mm bis 10 mm über dem Gefäßboden (4) des Reservoirs (7) angeordnet sind.

11. Reaktionsgefäß nach einem der vorhergehenden Ansprüche, **dadurch gekennzeichnet, dass** die Reaktionsbereiche (8) der Gefäßunterteile (2) durch Ausnehmungen mit einem Volumen im Bereich kleiner als 5 µl ausgebildet sind.

12. Reaktionsgefäß nach einem der vorhergehenden Ansprüche, **dadurch gekennzeichnet, dass** die Ausnehmungen in Form eines plattenförmigen, quadratischen Quaders oder zylinderscheibenförmig ausgebildet sind.

13. Reaktionsgefäß nach einem der vorhergehenden Ansprüche, **dadurch gekennzeichnet, dass** Böden der Ausnehmungen in Bezug auf diese zumindest annähernd konvex gekrümmt sind.

14. Reaktionsgefäß nach einem der vorhergehenden Ansprüche, **dadurch gekennzeichnet, dass** in Draufsicht auf die Aufstandsebene (13) die Reihen der Reaktionsbereiche (8) des Gehäuseunterteils (19) jeweils neben den Reihen der Reservoirs (7) liegen.

15. Reaktionsgefäß nach einem der vorhergehenden Ansprüche, **dadurch gekennzeichnet, dass** der auf eine zur Aufstandsebene (13) parallele Ebene bezogene Querschnitt der Reservoirs (7) rechteckig ist.

16. Reaktionsgefäß nach einem der vorhergehenden Ansprüche, **dadurch gekennzeichnet, dass** der Rahmen (20) des Gehäuseunterteils (19) und die Anordnung der Reaktionskammern (6) gemäß einer Standardgröße einer Mikrotiterplatte ausgebildet sind.

17. Reaktionsgefäß nach einem der vorhergehenden Ansprüche, **dadurch gekennzeichnet, dass** im Gehäuseunterteil (19) eine vorbestimmbare Anzahl an Reaktionskammern (6) ausgebildet ist, wobei die Anzahl aus einer Gruppe ausgewählt ist, die die Zahlen, gebildet durch die mathematische Formel 3 x 2^{N}, wobei N eine natürliche Zahl ist, umfasst.

18. Reaktionsgefäß nach einem der vorhergehenden Ansprüche, **dadurch gekennzeichnet, dass** der Gehäuseunterteil (19) aus einem lichtdurchlässigen Kunststoff ausgebildet ist.

19. Reaktionsgefäß nach einem der vorhergehenden Ansprüche, **dadurch gekennzeichnet, dass** an einem Rand (27) der Unterseite (28) der Gefäßabdeckung (25) ein über die Unterseite (28) vorstehender Rahmen (26) ausgebildet ist.

20. Reaktionsgefäß nach einem der vorhergehenden Ansprüche, **dadurch gekennzeichnet, dass** die Gefäßoberteile (3) mit mehreren Reaktionsbereichen (15) ausgebildet sind.

21. Reaktionsgefäß nach einem der vorhergehenden Ansprüche, **dadurch gekennzeichnet, dass** die Gefäßoberteile (3) mit zwei Reaktionsbereichen (15) ausgebildet sind.

22. Reaktionasgefäß nach einem der vorhergehenden Ansprüche, **dadurch gekennzeichnet, dass** die Reaktionsbereiche (15) der Gefäßoberteile (3) zur Aufnahme von Flüssigkeiten ausgebildet sind.

23. Reaktionsgefäß nach einem der vorhergehenden Ansprüche, **dadurch gekennzeichnet, dass** die Reaktionsbereiche (15) der Gefäßoberteile (3) durch Ausnehmungen ausgebildet sind.

24. Reaktionsgefäß nach einem der vorhergehenden Ansprüche, **dadurch gekennzeichnet, dass** die Ausnehmungen der Gefäßoberteil (3) zylinderscheibenförmig oder in Form eines plattenförmigen, quadratischen Quaders ausgebildet sind.

25. Reaktionsgefäß nach einem der vorhergehenden Ansprüche, **dadurch gekennzeichnet, dass** die Ausnehmungen der Gefäßoberteile (3) mit einem Volumen im Bereich kleiner als 5 µl ausgebildet sind.

26. Reaktionsgefäß nach einem der vorhergehenden Ansprüche, **dadurch gekennzeichnet, dass** Böden der die Reaktionsbereiche (15) bildenden Ausnehmungen der Gefäßoberteile (3) in Bezug auf diese Ausnehmungen zumindest annähernd konvex gekrümmt sind.

27. Reaktionsgefäß nach einem der vorhergehenden Ansprüche, **dadurch gekennzeichnet, dass** in Draufsicht auf die Aufstandsebene (13) die Reihen der Reaktionsbereiche (15) der Gefäßabdeckung (25) jeweils neben den gegebenenfalls vorhandenen Reihen der Reaktionsbereiche (8) des Gehäuseunterteils (19) liegen.

28. Reaktionsgefäß nach einem der vorhergehenden Ansprüche, **dadurch gekennzeichnet, dass** der Rahmen (26) der Gefäßabdeckung (25) und die Anordnung der Gefäßoberteile (3) gemäß einer Standardgröße einer Mikrotiterplatte ausgebildet sind.

29. Reaktionsgefäß nach einem der vorhergehenden Ansprüche, **dadurch gekennzeichnest, dass** in der Gefäßabdeckung (25) eine vorbestimmbare Anzahl an Gefäßoberteilen (3) ausgebildet ist, wobei die Anzahl aus einer Gruppe ausgewählt ist, die die Zahlen, gebildet durch die mathematische Formel 3 x 2^{N}, wobei N eine natürliche Zahl ist, umfasst.

30. Reaktionsgefäß nach einem der vorhergehenden Ansprüche, **dadurch gekennzeichnet, dass** die Gefäßabdeckung (25) aus einem lichtdurchlässingen Kunststoff ausgebildet ist.

31. Reaktionsgefäß nach einem der vorhergehenden Ansprüche, **dadurch gekennzeichnet, dass** an der Gefäßabdeckung (25) an einer den Reaktionsbereichen (15) abgewandten Oberfläche eine Maske (17) aufgebracht ist und diese Maske (17) bei Draufsicht auf die Aufstandsebene (13) die Reaktionsbereiche (15) mit einer lichtabschirmenden Fläche umgibt.

32. Reaktionsgefäß nach einem der vorhergehenden Ansprüche, **dadurch gekennzeichnet, dass** die Reaktionskammern (6) in der Form von Prismen mit einer regelmäßig sechseckigen Grundfläche ausgebildet sind.

33. Reaktionsgefäß nach einem der vorhergehenden Ansprüche, **dadurch gekennzeichnet, dass** die Reaktionsbereiche (8, 15) gefäßartig ausgebildet sind und jeweils zwei durch eine gemeinsame Wand (12) voneinander getrennt sind.

34. Gefäßabdeckung zur Herstellung einer Probe, insbesondere eines Kristalls, von einer sich in Lösung befindlichen oder flüssigen Substanz mit mehreren Reaktionsbereichen an einer Unterseite, wobei die Reaktionsbereiche (15) jeweils in Reihen mit einer vorbestimmbaren Teilung angeordnet sind, **dadurch gekennzeichnet, dass** diese Reihen parallel zueinander verlaufen und die Reaktionsbereiche (15) durch Ausnehmungen ausgebildet sind, und wobei die Ausnehmungen mit einem Volumen im Bereich kleiner als 5 µl ausgebildet sind.

35. Gefäßabdeckung nach Anspruch 3 4, **dadurch gekennzeichnet, dass** die Reaktionsbereiche (15) in Reihen mit einer gleichen Teilung angeordnet sind.

36. Gefäßabdeckung nach Anspruch 34 oder 3 5, **dadurch gekennzeichnet, daß** die Reaktionsbereiche (15) in Reihen unmittelbar nebeneinander angeordnet sind.

37. Gefäßabdeckung nach einem der Ansprüche 34 bis 36, **dadurch gekennzeichnet, dass** an einem Rand (27) der Unterseite (28) ein über die Unterseite (28) vorstehender Rahmen (26) ausgebildet ist.

38. Gefäßabdeckung nach einem der Ansprüche 34 bis 37, **dadurch gekennzeichnet, dass** an der Unterseite (28) Nuten (29) ausgebildet sind, durch die Gefäßoberteile (3), denen zumindest ein Reaktionsbereich (15) zugeordnet ist, begrenzt sind.

39. Gefäßabdeckung nach einem der Ansprüche 34 bis 38, **dadurch gekennzeichnet, dass** die Reaktionsbereiche (15) zur Aufnahme von Flüssigkeiten ausgebildet sind.

40. GeFäßabdeckung nach einem der Ansprüche 34 bis 39, **dadurch gekennzeichnet, dass** die Ausnehmungen zylinderscheibenförmig ausgebildet sind.

41. Gefäßabdeckung nach einem der Ansprüche 34 bis 40, **dadurch gekennzeichnet, dass** Böden der Ausnehmungen in Bezug auf diese zumindest annähernd konvex gekrümmt sind.

42. Gefäßabdeckung nach einem der Ansprüche 34 bis 41, **dadurch gekennzeichnet, dass** der Rahmen (26) und die Anordnung der Gefäßoberteile (3) gemäß einer Standardgröße einer Mikrotiterplatte ausgebildet sind.

43. Gefäßabdeckung nach einem der Ansprüche 34 bis 42, **dadurch gekennzeichnet, dass** eine vorbestimmbare Anzahl an Gefäßoberteilen (3) ausgebildet ist, wobei die Anzahl aus einer Gruppe ausgewählt ist, die die Zahlen, gebildet durch die mathematische Formel 3 x 2N, wobei N eine natürliche Zahl ist, unfasst.

44. Gefäßabdeckung nach einem der Ansprüche 34 bis 43, **dadurch gekennzeichnet, dass** das Material ein lichtdurchlässiger Kunststoff ist.

45. Gefäßabdeckung nach einem der Ansprüche 34 bis 44, **dadurch gekennzeichnct, dass** an der den Reaktionsbereichen (15) abgewandten Oberfläche eine Maske (17) aufgebracht ist und diese Maske (17) bei Draufsicht auf die Aufstandsebene (13) die Reaktionsbereiche (15) mit einer lichtabschirmenden Fläche umgibt.

## Claims

1. Reaction vessel comprising a housing bottom part (2) and an at least substantially lid-type vessel cover (25) for producing a sample, in particular a crystal, from a liquid substance or a substance in solution, comprising a plurality of identical reaction chambers (6), each forming a separate gas chamber, and formed by the housing bottom part (2), each reaction chamber (6) having a reservoir (7) and a plurality of reaction zones (8, 15) co-operating therewith which are linked to one another and to the reservoir (7) in order to effect a gas exchange, and the reservoirs (7) and the reaction zones (8, 15) co-operating with them are respectively disposed in rows extending parallel with one another at a predefined, identical pitch, and consecutive rows of reservoirs (7) are each spaced at an identical distance from one another, **characterised in that** the reservoirs (7) and the reaction zones (8, 15) are disposed respectively in rows directly adjacent to one another and respective directly adjacent reaction chambers (6) are delimited from one another by a common vessel wall (5), and the lid-type vessel cover (25) has grooves (29) on a bottom face (28), and vessel top parts (3) containing at least one reaction zone (15) are bounded by the grooves (29), and the grooves (29) are disposed so that they can be placed on the vessel walls (5) of the housing bottom part (2).

2. Reaction vessel as claimed in claim 1, **characterised in that** bottom faces (23) of vessel bases (4) of the reaction chambers (6) are in contact with a plane extending parallel with a support plane (13).

3. Reaction vessel as claimed in claim 1 or 2, **characterised in that** respective consecutive rows of reservoirs (7) are disposed at a pre-definable distance apart from one another.

4. Reaction vessel as claimed in one of the preceding claims, **characterised in that** respective immediately adjacent reservoirs (7) of two consecutive rows are mutually offset from one another at a pre-definable identical distance and in the same direction relative to the direction of the rows.

5. Reaction vessel as claimed in one of the preceding claims, **characterised in that** the reservoirs (7) are disposed in a rectangular lattice pattern.

6. Reaction vessel as claimed in one of the preceding claims, **characterised in that** a housing part comprises an at least substantially plate-shaped housing bottom part (19) comprising the vessel bottom parts (2) associated with the reaction chambers (6) and a frame (20) extending at the side of an edge (21) of a top face (22) of the housing bottom part (19) in the direction towards the bottom faces (23) of the vessel bases (4).

7. Reaction vessel as claimed in one of the preceding claims, **characterised in that** the vessel bottom parts (2) have at least one reservoir (7) and at least one reaction zone (8).

8. Reaction vessel as claimed in one of the preceding claims, **characterised in that** three or more reaction zones (8) are disposed in the vessel bottom parts (2).

9. Reaction vessel as claimed in one of the preceding claims, **characterised in that** the reservoirs (7) and the reaction zones (8, 15) are designed to hold liquids.

10. Reaction vessel as claimed in one of the preceding claims, **characterised in that** the reaction zones (8) of the vessel bottom parts (2) are disposed at a height (11) in the range of between 5 mm and 10 mm above the vessel base (4) of the reservoir (7).

11. Reaction vessel as claimed in one of the preceding claims, **characterised in that** the reaction zones (8) of the vessel bottom parts (2) have recesses with a capacity in the range of less than 5µl.

12. Reaction vessel as claimed in one of the preceding claims, **characterised in that** the recesses are provided in the form of a plate-shaped, square cuboid or are of a cylindrical disc shape.

13. Reaction vessel as claimed in one of the preceding claims, **characterised in that** bases of the recesses are at least substantially convexly curved relative to the latter.

14. Reaction vessel as claimed in one of the preceding claims, **characterised in that** the rows of reaction zones (8) of the housing bottom part (19) lie respectively adjacent to the rows of reservoirs (7) as seen in a plan view onto the support plane (13).

15. Reaction vessel as claimed in one of the preceding claims, **characterised in that** the cross section of the reservoir (7) relative to a plane parallel with the support plane (13) is rectangular.

16. Reaction vessel as claimed in one of the preceding claims, **characterised in that** the frame (20) of the housing bottom part (19) and the layout of the reaction chambers (6) correspond to a standard size of microtitre plate.

17. Reaction vessel as claimed in one of the preceding claims, **characterised in that** a pre-definable number of reaction chambers (6) is disposed in the housing bottom part (19), the number being selected from a group comprising the products of the mathematical formula 3 x 2^{N} in which N stands for a whole number.

18. Reaction vessel as claimed in one of the preceding claims, **characterised in that** the housing bottom part (19) is made from a transparent plastic.

19. Reaction vessel as claimed in one of the preceding claims, **characterised in that** a a frame (26) projecting out from the bottom face (28) is provided at an edge (27) of the bottom face (28) of the vessel cover (25).

20. Reaction vessel as claimed in one of the preceding claims, **characterised in that** the vessel top parts (3) have a plurality of reaction zones (15).

21. Reaction vessel as claimed in one of the preceding claims, **characterised in that** the vessel top parts (3) have two reaction zones (15).

22. Reaction vessel as claimed in one of the preceding claims, **characterised in that** the reaction zones (15) of the vessel top parts (3) are designed to hold liquids.

23. Reaction vessel as claimed in one of the preceding claims, **characterised in that** the reaction zones (15) of the vessel top parts (3) are recesses.

24. Reaction vessel as claimed in one of the preceding claims, **characterised in that** the recesses of the vessel top parts (3) are of a cylindrical disc shape or are provided in the form of a plate-shaped, square cuboid.

25. Reaction vessel as claimed in one of the preceding claims, **characterised in that** the recesses of the vessel top parts (3) have a capacity in the range of less than 5 µl.

26. Reaction vessel as claimed in one of the preceding claims, **characterised in that** bases of the recesses in the vessel top parts (3) forming the reaction zones (15) are at least substantially convexly curved relative to these recesses.

27. Reaction vessel as claimed in one of the preceding claims, **characterised in that** the rows of reaction zones (15) of the vessel cover (25) lie respectively adjacent to the optionally provided rows of reaction zones (8) of the housing bottom part (19) as seen in a plan view onto the support plane (13).

28. Reaction vessel as claimed in one of the preceding claims, **characterised in that** the frame (26) of the vessel cover (25) and the layout of the vessel top parts (3) correspond to a standard size of microtitre plate.

29. Reaction vessel as claimed in one of the preceding claims, **characterised in that** the vessel cover (25) has a pre-definable number of vessel top parts (3), the number being selected from a group comprising the products of the mathematical formula 3 x 2^{N} in which N stands for a whole number.

30. Reaction vessel as claimed in one of the preceding claims, **characterised in that** the vessel cover (25) is made from a transparent plastic.

31. Reaction vessel as claimed in one of the preceding claims, **characterised in that** a mask (17) is applied to the vessel cover (25) on a surface facing away from the reaction zones (15) and this mask (17) surrounds the reaction zones (15) with a light-screening surface as seen in a plan view onto the support plane (13).

32. Reaction vessel as claimed in one of the preceding claims, **characterised in that** the reaction chambers (6) are provided in the form of prisms with a regular hexagonal base surface.

33. Reaction vessel as claimed in one of the preceding claims, **characterised in that** the reaction zones (8, 15) are of a vessel-type design and every two are separated from one another by a common wall (12).

34. Vessel cover for producing a sample, in particular a crystal, from a liquid substance or a substance in solution, with a plurality of reaction zones on a bottom face, in which the reaction zones (15) are respectively disposed in rows at a pre-definable pitch, **characterised in that** these rows extend parallel with one another and the reaction zones (15) are recesses, and the recesses have a capacity in the range of less than 5 µl.

35. Vessel cover as claimed in claim 34, **characterised in that** the reaction zones (15) are disposed in rows at an identical pitch.

36. Vessel cover as claimed in claim 34 or 35, **characterised in that** the reaction zones (15) are disposed in rows immediately adjacent to one another.

37. Vessel cover as claimed in one of claims 34 to 36, **characterised in that** a frame (26) projecting out from the bottom face (28) is provided at an edge (27) of the bottom face (28).

38. Vessel cover as claimed in one of claims 34 to 37, **characterised in that** the bottom face (28) has grooves (29) delimiting providing vessel top parts (3) with at least one reaction zone (15).

39. Vessel cover as claimed in one of claims 34 to 38, **characterised in that** the reaction zones (15) are designed to hold liquids.

40. Vessel cover as claimed in one of claims 34 to 39, **characterised in that** the recesses are of a cylindrical disc shape.

41. Vessel cover as claimed in one of claims 34 to 40, **characterised in that** bases of the recess are at least substantially convexly curved relative to the latter.

42. Vessel cover as claimed in one of claims 34 to 41, **characterised in that** the frame (26) and the layout of the vessel top parts (3) correspond to a standard size of microtitre plate.

43. Vessel cover as claimed in one of claims 34 to 42, **characterised in that** a pre-definable number of vessel top parts (3) is provided, the number being selected from a group comprising the products of the mathematical formula 3 x 2^{N} in which N stands for a whole number.

44. Vessel cover as claimed in one of claims 34 to 43, **characterised in that** the material is a transparent plastic.

45. Vessel cover as claimed in one of claims 34 to 44, **characterised in that** a mask (17) is applied to the surface facing away from the reaction zones (15) and this mask (17) surrounds the reaction zones (15) with a light-screening surface as seen in a plan view onto the support plane (13).

## Revendications

1. Récipient de réaction constitué d'une partie inférieure de boîtier (19) et d'un recouvrement de récipient (25) au moins approximativement en forme de couvercle pour la production d'un échantillon, en particulier d'un cristal, d'une substance liquide ou en solution avec plusieurs chambres de réaction (6) formant chacune une enceinte de gaz propre, qui sont de même construction et sont formées par la partie inférieure de boîtier, où chaque chambre de réaction (6) présente un réservoir (7) et plusieurs zones de réaction (8, 15) associées à celui-ci, reliées en vue d'un échange des gaz entre elles et au réservoir (7), et les réservoirs (7) et les zones de réaction (8, 15) associées à ceux-ci sont disposés respectivement dans des rangées s'étendant parallèlement les unes aux autres avec une même séparation pouvant être prédéterminée, et des rangées respectivement successives de réservoirs (7) sont disposées à une même distance les unes des autres, **caractérisé en ce que** les réservoirs (7) et les zones de réaction (8, 15) sont disposés respectivement dans les rangées directement les unes à côté des autres et **en ce que** des chambres de réaction à chaque fois directement avoisinantes (6) sont séparées par une paroi de récipient commune (5) les unes des autres, et **en ce que** le recouvrement de récipient (25) est réalisé avec des rainures (29) à un côté inférieur (28), et par les rainures (29) sont délimitées des parties supérieures de récipient (3), qui contiennent au moins une zone de réaction (15), où les rainures (29) sont disposées de telle sorte qu'elles peuvent être placées sur les parois de récipient (5) de la partie inférieure de boîtier (19).

2. Récipient de réaction selon la revendication 1, **caractérisé en ce que** des côtés inférieurs (23) de fonds de récipient (4) des chambres de réaction (6) sont touchés par un plan parallèle à un plan d'appui (13).

3. Récipient de réaction selon la revendication 1 ou 2, **caractérisé en ce que** des rangées respectivement suivantes de réservoirs (7) sont disposées à un écart pouvant être prédéterminé.

4. Récipient de réaction selon l'une des revendications précédentes, **caractérisé en ce que** respectivement des réservoirs (7) les plus proches les uns des autres de deux rangées successives sont décalés les uns relativement aux autres selon un même écart pouvant être prédéterminé et dans la même direction relativement à la direction des rangées.

5. Récipient de réaction selon l'une des revendications précédentes, **caractérisé en ce que** les réservoirs (7) sont disposés selon une trame rectangulaire.

6. Récipient de réaction selon l'une des revendications précédentes, **caractérisé en ce qu'**il est réalisé comme une partie de boîtier une partie inférieure de boîtier (19) au moins approximativement en forme de plaque, qui est constituée de parties inférieures de récipient (2) associées aux chambres de réaction (6) et d'un châssis (20) s'étendant latéralement d'un bord (21) d'un côté supérieur (22) de la partie inférieure de boîtier (19) en direction des côtés inférieurs (23) des fonds de récipient (4).

7. Récipient de réaction selon l'une des revendications précédentes, **caractérisé en ce que** les parties inférieurs de récipient (2) sont formées par au moins un réservoir (7) et au moins une zone de réaction (8).

8. Récipient de réaction selon l'une des revendications précédentes, **caractérisé en ce que** trois ou plusieurs zones de réaction (8) sont réalisées dans les parties inférieures de récipient (2).

9. Récipient de réaction selon l'une des revendications précédentes, **caractérisé en ce que** les réservoirs (7) et les zones de réaction (8, 15) sont réalisés pour recevoir des liquides.

10. Récipient de réaction selon l'une des revendications précédentes, **caractérisé en ce que** les zones de réaction (8) des parties inférieures de récipient (2) sont disposées à une hauteur (11) dans la zone de 5 mm à 10 mm au-dessus du fond de récipient (4) du réservoir (7).

11. Récipient de réaction selon l'une des revendications précédentes, **caractérisé en ce que** les zones de réaction (8) des parties inférieures de récipient (2) sont réalisées par des évidements d'un volume dans une plage inférieure à 5 µl.

12. Récipient de réaction selon l'une des revendications précédentes, **caractérisé en ce que** les évidements sont réalisés sous la forme d'un parallélépipède quadratique en forme de plaque ou en forme de disque cylindrique.

13. Récipient de réaction selon l'une des revendications précédentes, **caractérisé en ce que** les fonds des évidements sont courbés d'une manière au moins approximativement convexe relativement à ceux-ci.

14. Récipient de réaction selon l'une des revendications précédentes, **caractérisé en ce que** dans une vue de dessus sur le plan d'appui (13), les rangées des zones de réaction (8) de la partie inférieure de boîtier (19) se situent à chaque fois à côté des rangées du réservoir (7).

15. Récipient de réaction selon l'une des revendications précédentes, **caractérisé en ce que** la section transversale, se rapportant à un plan parallèle au plan d'appui (13), du réservoir (7) est rectangulaire.

16. Récipient de réaction selon l'une des revendications précédentes, **caractérisé en ce que** le cadre (20) de la partie inférieure de boîtier (19) et l'agencement des chambres de réaction (6) sont réalisés en une grandeur standard d'une plaque de microtitrage.

17. Récipient de réaction selon l'une des revendications précédentes, **caractérisé en ce qu'**un nombre prédéfinissable de chambres de réaction (6) est réalisé dans la partie inférieure de boîtier (19), où le nombre est sélectionné d'un groupe qui comprend les chiffres, formés par la formule mathématique 3 x 2^{N}, où N est un nombre naturel.

18. Récipient de réaction selon l'une des revendications précédentes, **caractérisé en ce que** la partie inférieure de boîtier (19) est réalisée en un matériau synthétique transparent.

19. Récipient de réaction selon l'une des revendications précédentes, **caractérisé en ce qu'**il est réalisé à un bord (27) du côté inférieur (28) du recouvrement de récipient (25) un châssis (26) faisant saillie sur le côté inférieur (28).

20. Récipient de réaction selon l'une des revendications précédentes, **caractérisé en ce que** les parties supérieures de récipient (3) sont réalisées avec plusieurs zones de réaction (15).

21. Récipient de réaction selon l'une des revendications précédentes, **caractérisé en ce que** les parties supérieures de récipient (3) sont réalisées avec deux zones de réaction (15).

22. Récipient de réaction selon l'une des revendications précédentes, **caractérisé en ce que** les zones de réaction (15) des parties supérieures de récipient (3) sont réalisées pour la réception de liquides.

23. Récipient de réaction selon l'une des revendications précédentes, **caractérisé en ce que** les zones de réaction (15) des parties supérieures de récipient (3) sont réalisées par des évidements.

24. Récipient de réaction selon l'une des revendications précédentes, **caractérisé en ce que** les évidements des parties supérieures de récipient (3) sont réalisés en forme de disque cylindrique ou sous la forme d'un parallélépipède quadratique en forme de plaque.

25. Récipient de réaction selon l'une des revendications précédentes, **caractérisé en ce que** les évidements des parties supérieures de récipient (3) sont réalisés avec un volume dans la plage inférieure à 5 µl.

26. Récipient de réaction selon l'une des revendications précédentes, **caractérisé en ce que** des fonds des évidements des parties supérieures de récipient (3) formant les zones de réaction (15) sont courbés au moins d'une manière approximativement convexe relativement à ces évidements.

27. Récipient de réaction selon l'une des revendications précédentes, **caractérisé en ce que** dans une vue de dessus sur le plan d'appui (13), les rangées des zones de réaction (15) du recouvrement de récipient (25) se situent à chaque fois à côté des rangées le cas échéant présentes des zones de réaction (8) de la partie inférieure de boîtier (19).

28. Récipient de réaction selon l'une des revendications précédentes, **caractérisé en ce que** le cadre (26) du recouvrement de récipient (25) et l'agencement des parties supérieures de récipient (3) sont réalisés en une grandeur standard d'une plaque de microtitrage.

29. Récipient de réaction selon l'une des revendications précédentes, **caractérisé en ce qu'**il est réalisé dans le recouvrement de récipient (25) un nombre prédéfinissable de parties supérieures de récipient (3), où le nombre est sélectionné d'un groupe qui comprend les chiffres, formés par la formule mathématique 3 x 2^{N}, où N est un nombre naturel.

30. Récipient de réaction selon l'une des revendications précédentes, **caractérisé en ce que** le recouvrement de récipient (25) est réalisé en un matériau synthétique transparent.

31. Récipient de réaction selon l'une des revendications précédentes, **caractérisé en ce qu'**un masque (17) est appliqué au recouvrement de récipient (25) à une surface éloignée des zones de réaction (15), et ce masque (17), en vue de dessus sur le plan d'appui (13), entoure les zones de réaction (15) d'une face de protection contre la lumière.

32. Récipient de réaction selon l'une des revendications précédentes, **caractérisé en ce que** les chambres de réaction (6) sont réalisées sous la forme de prismes avec une face de base hexagonale régulière.

33. Récipient de réaction selon l'une des revendications précédentes, **caractérisé en ce que** les zones de réaction (8, 15) sont réalisées en forme de récipient et que respectivement deux sont séparées l'une de l'autre par une paroi commune (12).

34. Recouvrement de récipient pour produire un échantillon, en particulier un cristal, d'une substance en solution ou liquide avec plusieurs zones de réaction à un côté inférieur, où les zones de réaction (15) sont disposées respectivement en rangées avec une séparation prédéfinissable, **caractérisé en ce que** ces rangées s'étendent parallèlement les unes aux autres et que les zones de réaction (15) sont réalisées par des évidements, et où les évidements sont réalisés avec un volume dans la plage inférieure à 5µl.

35. Recouvrement de récipient selon la revendication 34, **caractérisé en ce que** les zones de réaction (15) sont disposées en rangées avec une même séparation.

36. Recouvrement de récipient selon la revendication 34 ou 35, **caractérisé en ce que** les zones de réaction (15) sont disposées en rangées directement les unes à côté des autres.

37. Recouvrement de récipient selon l'une des revendications 34 à 36, **caractérisé en ce qu'**il est réalisé à un bord (27) du côté inférieur (28) un châssis (26) faisant saillie sur le côté inférieur (28).

38. Recouvrement de récipient selon l'une des revendications 34 à 37, **caractérisé en ce qu'**au côté inférieur (28), des rainures (29) sont réalisées par lesquelles les parties supérieures de récipient (3), auxquelles est associée au moins une zone de réaction (15), sont délimitées.

39. Recouvrement de récipient selon l'une des revendications 34 à 38, **caractérisé en ce que** les zones de réaction (15) sont réalisées pour recevoir des liquides.

40. Recouvrement de récipient selon l'une des revendications 34 à 39, **caractérisé en ce que** les évidements sont réalisés en forme de disque cylindrique.

41. Recouvrement de récipient selon l'une des revendications 34 à 40, **caractérisé en ce que** les fonds des évidements sont courbés d'une manière au moins approximativement convexe relativement à ceux-ci.

42. Recouvrement de récipient selon l'une des revendications 34 à 41, **caractérisé en ce que** le châssis (26) et l'agencement des parties supérieures de récipient (3) sont réalisés en une grandeur standard d'une plaque de microtitrage.

43. Recouvrement de récipient selon l'une des revendications 34 à 42, **caractérisé en ce qu'**un nombre prédéfinissable de parties supérieures de récipient (3) est réalisé, où le nombre est sélectionné d'un groupe qui comprend les chiffres, formés par la formule mathématique 3 x 2^{N}, où N est un nombre naturel.

44. Recouvrement de récipient selon l'une des revendications 34 à 43, **caractérisé en ce que** le matériau est un matériau synthétique transparent.

45. Recouvrement de récipient selon l'une des revendications 34 à 44, **caractérisé en ce qu'**à la surface éloignée des zones de réaction (15), un masque (17) est appliqué, et ce masque (17), en une vue de dessus sur le plan d'appui (13), entoure les zones de réaction (15) d'une face de protection contre la lumière.
